# EUROPÄISCHE PATENTSCHRIFT

(11) **EP 0 436 603 B1**
(45) Veröffentlichungstag und Bekanntmachung des Hinweises auf die Patenterteilung: **13.04.1994**
(21) Anmeldenummer: 89910865.8
(22) Anmeldetag: 26.09.1989
(51) Int. Cl.: H03M 1/20, H03M 1/08

(54) **VERFAHREN UND VORRICHTUNG ZUR WANDLUNG DES ABTASTSIGNALS EINES ANALOGEN EINGANGSSIGNALS**
PROCESS AND DEVICE FOR CONVERTING THE SCANNING SIGNAL OF AN ANALOG INPUT SIGNAL
PROCEDE ET DISPOSITIF POUR CONVERTIR LE SIGNAL DE BALAYAGE D'UN SIGNAL D'ENTREE ANALOGIQUE

(30) Priorität: 29.09.1988 EP 88309066
(43) Veröffentlichungstag der Anmeldung: 17.07.1991
(73) Patentinhaber: Siemens Aktiengesellschaft Österreich, 1210 Wien (AT)
(72) Erfinder: BUSTANCE, C., David, Royston Hertfordshire (GB); LIDBETTER, Paul, Royston Hertfordshire (GB); LANCASTER, John, Cambridge (GB)
(74) Vertreter: Atzwanger, Richard, Dipl.-Ing. Patentanwalt
(86) Internationale Anmeldenummer: EP8901127
(87) Internationale Veröffentlichungsnummer: WO9003695

(56) Entgegenhaltungen:
- DE-A- 1 801 670
- DE-A- 2 026 643
- GB-A- 2 179 812
- US-A- 4 544 917
- ELECTRONIC ENGINEERING, Band 57, Nr. 704, August 1985, London, GB; L.M.RADHAKRISHNAN: "Two 8 bit DAC's make a 12 bit DAC", Seite 30

## Beschreibung

Die Erfindung betrifft ein Verfahren zur Wandlung des Abtastsignals eines analogen Eingangssignals in einen digitalen Ausgangswert zu L Datenbits, wobei das Abtastsignal in einen digitalen Referenzwert zu M < L Datenbits umgewandelt wird, der wiederum in ein analoges Referenzsignal rückgewandelt und vom Abtastsignal subtrahiert wird, wobei dieses Differenzsignal verstärkt und in einen digitalen Teilwert zu M < N < L Datenbits umgewandelt wird, der mit dem Referenzwert zum Ausgangswert mit L Datenbits zusammengefaßt wird, wobei vom Referenzwert die höherwertigeren und vom Teilwert die niederwertigeren Datenbits des Ausgangswertes gebildet werden und die Summe der Anzahl der Datenbits von Referenz- und Teilwert nicht kleiner als die Anzahl der Datenbits des Ausgangswertes ist.

Nach einem derartigen Verfahren arbeiten die aus Electronic Design, Band 35, Seite 119-122, "Comparing ADC architectures is a designer's best bet" und Funkschau, Nr. 7,Seite 57-60, "Video in Bits" bekannten Analog/Digital-Wandler (subranging Technik). Durch die Aufteilung der Wandlung in die Bildung des Referenz- und des Teilwertes wird nach deren Zusammenfassung eine Gesamtauflösung erreicht, die größer als die jeweilige Teilauflösung ist. Der Referenzwert ist dabei eine erste Näherung des Ausgangswertes. Das Differenzsignal enthält die Information, die unterhalb der Auflösungsgrenze des Referenzwertes liegt. In Funkschau, Nr. 7 werden Probleme und Fehler beschrieben, die bei dieser Art der Analog/Digital-Wandlung auftreten können. So führen diese Fehler beispielsweise bei Wandlern in Tonstudios zu hörbaren Störungen.

DE-A-2 026 643 offenbart einen Analog/Digital-Wandler nach dem Unterbereichsverfahren, bei dem aus einer elektrischen analogen Eingangsgröße in einem Analog/Digital-Wandler relativ geringer Genauigkeit zunächst ein erstes digitales Teilergebnis (Referenzwert) gebildet und gespeichert wird. Dieses Teilergebnis wird in einem Digital/Analog-Umsetzer der vollen, gewünschten Genauigkeit rückgewandelt und daraus die Differenz mit der Eingangsgröße gebildet. Schließlich wird nach Verstärkung dieser Differenzgröße ein zweites digitales Teilergebnis gewonnen, das in einem Ergebnisregister mit dem ersten Teilergebnis zum Ausgangswert zusammengesetzt wird. Ein ähnlicher Analog/Digital-Wandler ist auch in DE-A-1 801 670 beschrieben.

Der Erfindung liegt die Aufgabe zugrunde, Störungen bei der Bildung des Differenzsignals zu vermeiden.

Dies wird gemäß Patentanspruch 1 dadurch erreicht, daß der Referenzwert nur während einer Abtastperiode als Teil eines Arbeitszyklus gebildet und bis zur nächst folgenden Abtastperiode gehalten wird und daß die Subtrahierung des Referenzsignals unterdrückt wird, wenn der Pegel des Abtastsignals unter das minimale Quantisierungsniveau zur Referenzwertbildung absinkt.

Die im Differenzsignal enthaltene Information aus dem Bereich kleiner Eingangssignalpegeln wird mit hoher Auflösung und guter Linearität gewandelt. Da weiters der Teilwert bei der Bildung des Ausgangswertes nach unten verschoben wird, werden alle Fehler bei der Teilwertbildung im Verhältnis zum Ausgangswert abgesenkt. Spannungsspitzen bei der Bildung des Differenzsignals durch Laufzeitdifferenzen zwischen dem Abtastsignal und dem Referenzsignal werden durch die Aufteilung des Arbeitszyklus auf ein nicht mehr störendes Maß reduziert. Weiters erübrigt sich durch diese Betriebsweise ein Haltespeicher am Wandlerausgang. Die Differenz zwischen Referenz- und Abtastsignal darf nur so groß werden, daß der nachgeschaltete Verstärker nicht in den Sättigungsbereich gerät.

Zur optimalen Ausnutzung der verwendeten Bauelemente ist es vorteilhaft, daß die Summe der Datenbits von Referenz- und Teilwert nicht wesentlich größer als die Anzahl der Datenbits des Ausgangswertes ist und daß die überzähligen Datenbits zur Korrektur von Umwandlungsfehlern und zur Anzeige eines Überschreitens des Wertebereichs verwendet werden. Die Überlappung des Referenzmit dem Teilwert ermöglichst es, mit dem höchstwertigsten Bit des Teilwertes die Fehler bei der Referenzwertbildung zu eliminieren.

Die Erfindung betrifft weiter ein Verfahren zur Wandlung eines digitalen Eingangswertes in ein analoges Ausgangssignal, wobei der digitale Eingangswert in zwei Teilwerte aufgespalten und in analoge Teilsignale umgewandelt wird, wobei die höherwertigeren Bits des Eingangswertes den oberen Teilwert bilden und gleichzeitig mit den niederwertigeren Bits in analoge Teilsignale umgewandelt werden, wobei die Zahl der höherwertigeren Bits kleiner als die Zahl der niederwertigeren Bits ist und wobei die Teilsignale mit Pegelanpassung summiert und zum Ausgangssignal zusammengefaßt werden.

Nach einem derartigen Verfahren arbeitet der Digital/Analog-Wandler gemäß Electronic Engineering, Band 57, Nr. 704, August 1985, (London, GB), L.M. Radhakrishnan: "Two 8 bit DAC's make a 12 bit DAC", Seite 30. Die Pegelanpassung erfolgt lediglich über einen Widerstand. Es können hörbare Fehler bei der Verwendung niedrig auflösender Bauelemente auftreten.

Entsprechend der Analog/Digital-Wandlung liegt auch hier der Erfindung die Aufgabe zugrunde, Störungen bei der Bildung des Summensignals zu vermeiden.

Dies wird gemäß Patentanspruch 3 dadurch ereicht, daß zur Pegelanpassung in einer ersten Stufe der untere Teilwert um mehrere Bits zu niederwertigeren Stellen verschoben und in einer zweiten Stufe das untere Teilsignal um die noch verbleibende Pegeldifferenz gedämpft wird und daß ein digitaler Festwert zum Eingangswert addiert und das Teilsignal des oberen Teilwertes im entsprechenden Maß gedämpft wird, wenn Eingangswerte kleiner als der digitale Festwert sind.

Temperaturschwankungen bei der Strom-Spannungswandlung zur Teilsignalbildung und der Summierung, und die Alterung der verwendeten Bauteile lösen hörbare Verzerrungen bei Signalen mit niederem Pegel aus. Diese Verzerrungen werden durch die erfindungsgemäße Wandlung beseitigt. Es kommt zu einer Entkopplung des Spannungsnulldurchganges der Wandler vom bipolaren Nullpunkt des Eingangswertes. Weiters wird dadurch auch der Rauschpegel bei der Wandlung gesenkt.

Eine Vorrichtung zur Analog/Digital-Wandlung ist mit allgemein erhältlichen Bauteilen herstellbar, wobei das Eingangssignal einem Abtast-Halteglied zugeführt ist, dessen Ausgang mit dem Analogeingang eines M-Bit Parallel-A/D-Wandlers verbunden ist, wobei die Ausgänge des Parallel-A/D-Wandlers mit den Digitaleingängen eines Referenz-D/A-Wandlers und den höherwertigeren Eingängen eines L-Bit bistabilen Haltespeichers verbunden sind, wobei der Ausgang des Referenz- D/A-Wandlers mit dem Ausgang des Abtast-Haltegliedes in einem Differenzverstärker zusammengeführt ist, dessen Ausgang mit dem Analogeingang eines N-Bit Teilwert-A/D-Wandlers verbunden ist und wobei die Ausgänge des Teilwert-A/D-Wandlers mit den niederwertigeren Eingängen des Haltespeichers verbunden und Eingänge einer Korrekturschaltung mit den Ausgängen des Parallel-A/D-Wandlers verbunden sind, die zur Durchführung einer Fehlerkorrektur dadurch gekennzeichnet ist, daß ein weiterer Eingang der Korrekturschaltung mit dem höchstwertigsten Ausgang des Teilwert-A/D-Wandlers verbunden ist, daß Ausgänge der Korrekturschaltung mit den höherwertigeren Eingängen des Haltespeichers, ein Überlastausgang der Korrekturschaltung mit einem weiteren Eingang des Haltespeichers und ein Steuerausgang der Korrekturschaltung mit einer Rauschunterdrückungsschaltung verbunden sind und daß die Rauschunterdrückungsschaltung zur Unterdrückung des Referenzsignals bei einem Pegel des Abtastsignals unterhalb des minimalen Quantisierungsniveaus für die Referenzwertbildung zwischen den Referenz-D/A-Wandler und den Differenzverstärker geschaltet ist. Durch die schnelle Arbeitsweise des Parallel-A/D-Wandlers wird die Laufzeitdifferenz zwischen Abtast- und Referenzsignal so gering als möglich gehalten. Dieser Wandler hält den letzten Abtastwert bis zur nächsten Periode. Die Ausgabe des Überlastwertes ersetzt eine analoge Überlastanzeige. Bei dieser Schaltungsanordnung ist kein spezieller Abgleich einzelner Baugruppen notwendig.

Zur Digital/Analog-Wandlung mit allgemein erhältlichen Bauteilen ist es vorteilhaft, daß ein Datenbus für Eingangswerte mit einem Niederwert- und einem Oberwert-D/A-Wandler verbunden ist, deren Ausgänge in einem Summierverstärker zusammengefaßt sind, daß eine Rauschunterdrückungsschaltung zwischen dem Oberwert-D/A-Wandler und dem Summierverstärker angeordnet ist, daß die Rauschunterdrückungsschaltung zur Addition eines digitalen Festwertes über ein Gatter mit höchstwertigsten Leitungen des Datenbusses verbunden ist und daß mit einem Aufnahmespeicher ein Übertragungsspeicher in Serie geschaltet ist. Dadurch ist sichergestellt, daß bei einem Vielkanal-Audiosystem alle Kanäle zum selben Zeitpunkt die Eingangswerte übernehmen und keine Phasenfehler auftreten.

Die Erfindung wird anhand eines Ausführungsbeispieles mit zwei Zeichnungen näher erläutert. Es zeigen:
- Fig. 1: ein Blockschaltbild der Analog/Digital-Wandlerbaugruppe und
- Fig. 2: ein Blockschaltbild der Digital/Analog-Wandlerbaugruppe des Ausführungsbeispieles.

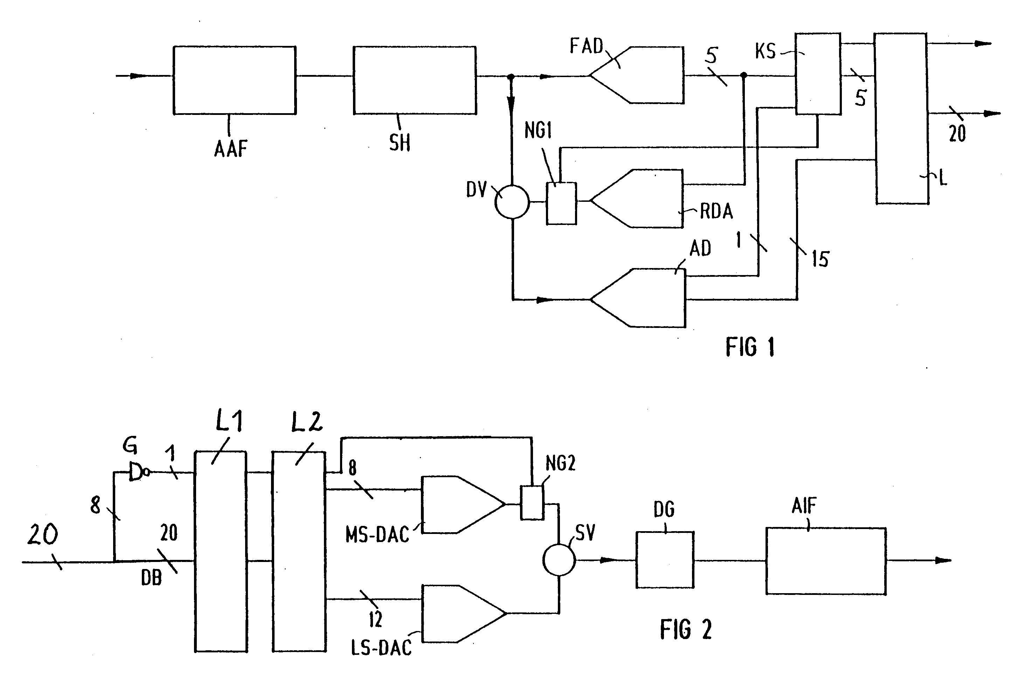

In Fig. 1 wird das Blockschaltbild einer 20-Bit Analog/Digital-Wandlerbaugruppe eines Tonkanales eines digitalen Studiomischpultes mit linearer Wandlercharakteristik gezeigt. Ein analoges Audiosignal liegt am Eingang eines Echofilters AAF an, der die Tonfrequenz auf maximal 20 kHz begrenzt. Dadurch werden höhere Frequenzen unterdrückt, die nach der Wandlung hörbar werden könnten. Aus diesem Signal wird von einem Abtast-Halteglied SH mit 48 kHz ein pulsamplitudenmoduliertes Abtastsignal mit diskreter Gleichspannung erzeugt, das in zwei parallelen Schritten in einen digitalen Ausgangswert umgewandelt wird.

Ein schneller 5-Bit Parallel-A/D-Wandler FAD erzeugt einen digitalen 5-Bit Näherungswert des Abtastsignals. Dieser Referenzwert wird einerseits einem Haltespeicher L als Teil des Ausgangswertes zugeleitet, andererseits als höchstwertigste Bits eines 16-Bit Referenz-D/A-Wandlers RDA in ein analoges Referenzsignal rückgewandelt und mit einem Differenzverstärker DV vom Abtastsignal subtrahiert. Dieses Differenzsignal wird um den Faktor 16 verstärkt und einem 16-Bit Teilwert-A/D-Wandler AD zugeführt. Das nunmehr höchstwertigste Bit des Teilwertes wird einer Korrekturschaltung KS zugeleitet und als digitaler Überlagerungswert zur Korrektur von Fehlern bei der Referenzwertbildung des Parallel-A/D-Wandlers FAD herangezogen. Es wird zum 5-Bit Referenzwert addiert, der gemeinsam mit dem Teilwert den 20-Bit Ausgangswert des analogen Audiosignals bildet. Im Haltespeicher L werden der Referenzwert als höherwertigerer Teil und die verbliebenen 15 Bits des Teilwertes als niederwertigerer Teil des Ausgangswertes zusammengefaßt.

Ist ein Audiosignal unter dem minimalen Quantisierungsniveau des Parallel-A/D-Wandlers FAD, so wird die Bildung des Referenzsignals unterdrückt. In diesem Fall beträgt daher der Verstärkungsfaktor des Differenzverstärkers DV 32. Das Signalniveau am Eingang des Teilwert-A/D-Wandler AD ist immer um 30 dB höher als am Eingang der gesamten Baugruppe. Bei der Bildung des Ausgangswertes wird der Teilwert dann um 30 dB nach unten verschoben. Damit werden alle bei der Wandlung auftretenden Fehler des Teilwert-A/D-Wandlers AD um 30 dB abgesenkt. Das ergibt eine sehr gute 20-Bit Linearität des Ausgangswertes, dessen Pegel mehr als 30 dB unter dem Maximalwert liegt. Dieser Bereich ist für Audiosignale von besonderer Bedeutung, da Fehler gut hörbar wären. Die einzige Begrenzung der Gesamtgenauigkeit der Analog/Digital-Wandlung bei Abtastsignalen oberhalb des minimalen Quantisierungsniveaus des Parallel-A/D-Wandlers FAD ist bei Verwendung der Korrekturschaltung KS die Genauigkeit des Referenz-D/A-Wandlers RDA.

Der Echofilter AAF besteht aus einem Operationsverstärker (1/2 NE 5532), einem Butterworth-Tiefpaßfilter 4. Ordnung und einem passiven Filter 1. Ordnung. Dadurch wird das Breitbandrauschen und die Phasendispersion der Filter vermindert. Im Abtast-Halteglied SH wird die Isolation zwischen dem Abtastsignal und den Haltekondensatoren durch zwei duale Feldeffekttransistoren (2x N 5911) verbessert. Eine Entladung der Haltekondensatoren wird durch Integration mit einem Operationsverstärker (LF 356) verhindert.

Der Parallel-A/D-Wandler FAD ist unipolar und vom Typ MP 7682. Er besitzt eine Auflösung von 6 Bit und ist auf 5 Bit geschaltet. Die Ausgangsspannung des Abtast-Haltegliedes SH wird über Widerstände entsprechend angepaßt. Der Parallel-A/D-Wandler FAD wird in einem Teilmodus betrieben. Er wird während eines Arbeitszyklus nur in der Abtastperiode des Abtast-Haltegliedes SH mit 3,072 MHz getaktet und verbleibt bis zur nächstfolgenden Abtastperiode in Bereitschaftsstellung (stand-by). Dabei wird der letzte Wert am Wandlerausgang bis zur nächsten Taktimpulsfolge gehalten.

Zur Erzielung einer hohen Genauigkeit wird ein 14-Bit-Wandler (ADG 7538) als Referenz-D/A-Wandler RDA verwendet und so beschaltet, daß er als 5-Bit Wandler arbeitet. Dieser Wandler bestimmt wesentlich die Genauigkeit des Ausgangswertes der gesamten Baugruppe. Zur Verminderung des Rauschens wird statt des Spannungsausganges der Stromausgang verwendet und das Spannungssignal durch zwei rauscharme Operationsverstärker erzeugt. Die 5 Ausgangsbits des Parallel-A/D-Wandlers FAD werden den 5 höchstwertigsten Eingängen des Referenz-D/A-Wandlers RDA zugeleitet. Eine erste Rauschunterdrückungsschaltung NG1, bestehend aus einem Feldeffekttransistor (J 110) und einem Widerstand (200 Ohm), ist als Spannungsteiler mit dem Referenz-D/A-Wandlers RDA verbunden. Sie senkt die Referenzspannung um etwa 26 dB ab, wenn kein gültiger Wert am Eingang des Referenz-D/A-Wandlers RDA anliegt. Ein gültiger Wert am Ausgang des Parallel-A/D-Wandlers FAD bewirkt das Abschalten des Feldeffekttransistors, und der Ausgang des Referenz-D/A-Wandlers RDA wird mit dem Differenzverstärker DV verbunden.

Der Differenzverstärker DV besteht aus einem Operationsverstärker (NE 5534), der invertierend an virtueller Erde betrieben wird. Der nominelle Spannungsverstärkungsfaktor ist 4. Das Abtastsignal am Ausgang des Abtast-Haltegliedes SH wird mit dem invertierten Referenzsignal gemischt. Aus diesem Differenzsignal wird durch den Teilwert-A/D-Wandler AD der Teilwert gebildet. Eine Verzögerung zwischen dem Abtastsignal und dem Referenzsignal am Eingang des Differenzverstärkers DV kann Spannungsspitzen erzeugen. Insbesondere bei hochfrequenten Audiosignalen käme es dann zu starken harmonischen Verzerrungen. Um dieses Problem zu lösen, könnte der Ausgang des Differenzverstärkers DV durch einen Analogschalter solange abgeschaltet werden, bis das Differenzsignal stabil ist. Zur Impedanzanoassung dieses Analogschalters an den Teilwert-A/D-Wandler AD wäre aber ein zusätzlicher Operationsverstärker notwendig. Bei diesem Ausführungsbeispiel werden die Laufzeitdifferenzen und die daraus resultierenden Spannungsspitzen aber bereits dadurch auf ein nicht mehr störendes Maß reduziert, daß der Referenz-D/A-Wandler RDA im Teilmodus betrieben wird. Spannungsspitzen treten nur auf, wenn das Abtastsignal über dem minimalen Quantisierungsniveau des Parallel-A/D-Wandlers FAD ist. Andernfalls ist, wie bereits beschrieben, der Ausgang des Referenz-D/A-Wandlers RDA durch die erste Rauschunterdrückungsschaltung NG1 abgeschaltet.

Der Teilwert-A/D-Wandler AD bildet aus dem Differenzsignal die niederwertigeren Bits des digitalisierten Audiosignals. Es wird ein 16-Bit-Wandler (PCM 75) verwendet. In der noch verbleibenden Periodenzeit eines Arbeitszyklus von 13 µsec wird das Differenzsignal in den Teilwert umgewandelt. Der Spannungsbereiche am Eingang des Teilwert-A/D-Wandlers AD für das Differenzsignal ist auf ein Viertel des Spannungsbereiches des Audiosignals festgelegt. Das entspricht einem Verstärkungsfaktor 4. Zusammen mit dem Verstärkungsfaktor 4 des Operationsverstärkers im Differenzverstärker DV wird der gesamte Verstärkungsfaktor von 16, oder 24 dB, im analogen Bereich erreicht. Durch das Verschieben des digitalen Teilwertes wird eine weitere Verstärkung um 6 dB erreicht, da das 16. Bit (MSB) zur Fehlerkorrektur verwendet wird. Das nächstniederwertigere Bit ist Bit 6 des 20-Bit Ausgangswertes am Haltespeicher L.

Die Hauptaufgabe der Korrekturschaltung KS ist es, das höchstwertigste Bit des Teilwert-A/D-Wandlers AD zum niederwertigsten Bit des Parallel-A/D-Wandlers FAD zu addieren. Dieses Korrekturbit enthält alle Fehler, die bei der Parallelwandlung des Abtastsignals auftreten könnten. Bei Verwendung eines Binäraddierers (74LS283) müßte das Ausgangssignal digital begrenzt werden, um ein Überschreiten des Wertebereichs zu verhindern. Durch Verwendung eines programmierbaren Lesespeichers (AM27S29) wird das Additionsergebnis auf Werteüberlauf geprüft und gegebenenfalls auf den Maximalwert (hex3F) abgesenkt. Zusätzlich wird dann ein Überlastwert erzeugt. Der Ausgangswert wird in das Format des komplementären Zweierkomplements invertiert. Zeigt der Ausgang des Parallel-A/D-Wandlers FAD ein Unterschreiten des minimalen Quantisierungsniveaus an (hex1F), so wird über die Korrekturschaltung KS die erste Rauschunterdrückungsschaltung NG1 aktiviert.

Im Haltespeicher L (3x LS374) werden Teilwert und Referenzwert zum 20-Bit Ausgangswert zusammengeführt. Der 5-Bit Referenzwert bildet die höherwertigeren und der 15-Bit Teilwert die niederwertigeren Bits des Ausgangswertes. Zusätzlich wird der Überlastwert ausgegeben.

Fig. 2 Zeigt die Digital/Analog-Wandlerbaugruppe, die einen 20-Bit Eingangswert in ein analoges Audiosignal umwandelt. Der Eingangswert wird von einem Datenbus DB in einen Aufnahmespeicher L1 übernommen und an einen Übertragungsspeicher L2 weitergeleitet. Somit ist die gleichzeitige Datenwandlung auch bei Vielkanal-Systemen gewährleistet. Aufnahme- und Übertragungsspeicher L1, L2 sind aus D-Flip-Flops (je 3x 74LS374) aufgebaut. Vom Übertragungsspeicher L2 werden die acht höherwertigen Bits als Näherung des Eingangswertes invertiert zu einem Oberwert-D/A-Wandler MS-DAC übertragen. Die zwölf niederwertigeren Bits werden direkt einem Niederwert-D/A-Wandler LS-DAC zugeleitet.

Als Niederwert- und Oberwert-D/A-Wandler LS-DAC, MS-DAC werden preiswerte Wandler (PCM 54 KP) verwendet. Dadurch kann eine leistungsfähige, lineare 20-Bit Digital/Analog-Wandlerbaugruppe mit einer Arbeitsfrequenz vom bis zu Vierfachen der Abtastrate von 48 kHz aufgebaut werden. Bevor die Ausgänge des Niederwert- und Oberwert-D/A-Wandlers LS-DAC, MS-DAC summiert werden, müssen die Pegel so angepaßt werden, daß der Wert des höchstwertigen Bits des Niederwert-D/A-Wandlers LS-DAC die Hälfte des Wertes des niederwertigsten Bits des Oberwert-D/A-Wandlers MS-DAC beträgt. Das bedeutet, daß das Teilsignal am Ausgang des Niederwert-D/A-Wandlers LS-DAC um 48 dB zu dämpfen ist. Dies geschieht in zwei Stufen. In der ersten wird der digitale Eingangswert des Niederwert-D/A-Wandlers LS-DAC um vier Bits nach unten verschoben, was einer Dämpfung um 24 dB entspricht. Die restliche Dämpfung erfolgt bei der Strom-Spannungswandlung des analogen Teilsignals.

Da der Spannungsausgang der verwendeten Wandlertypen einen hohen Rauschpegel aufweist, der teilweise durch den internen Strom-Spannungsverstärker verursacht wird, werden extern rauscharme Operationsverstärker (NE 5532) zur Strom-Spannungswandlung verwendet. Durch eine zweite Verstärkerstufe mit einem invertierenden Operationsverstärker an virtueller Erde wird in einem Summierverstärker SV die Ausgangsspannung des Oberwert-D/A-Wandlers MS-DAC um 19,2 dB angehoben und im Niederwert-D/A-Wandler LS-DAC um 4,8 dB abgesenkt. Damit ist die genaue Pegelanpassung der beiden Teilsignale vollzogen. Die Summenbildung erfolgt in einem rauscharmen Operationsverstärker (NE 5532) mit Verstärkungsfaktor 2,5 dB.

Temperaturschwankungen bei der Strom-Spannungswandlung und der Summierung, und die Alterung der verwendeten Komponenten lösen hörbare Verzerrungen bei Signalen mit niederem Pegel aus. Zur Beseitigung dieser Fehlerquelle wird eine zweite Rauschunterdrückungsschaltung NG2 verwendet. Ein digitaler Festwert (digitaler Offset), der einem Gleichstrom entspricht, wird vor dem Aufnahmespeicher L1 zum Eingangswert addiert, wodurch der Spannungsnulldurchgang der Wandler nicht mit einer Polaritätsänderung des Eingangswertes verbunden ist. Interferenzen, die beim gleichzeitigen Umklappen aller 20 Bits entstehen, werden vermieden. Der Nulldurchgang wird für die Verarbeitung der Audiosignale stark angehoben (hex355). Der digitale Festwert senkt auch den Rauschpegel, der durch die Digital/Analog-Wandlung im Wandler erzeugt wird. Ein NAND-Gatter G mit acht Eingängen (74LS30) wird mit den acht Bits des Teilwertes des Oberwert-D/A- Wandlers MS-DAC verbunden. Durch dieses Gatters G wird die zweite Rauschunterdrückungsschaltung NG2 kontrolliert, die als Spannungsteiler aus einem Widerstand (390 Ohm) und einem Feldeffekttransistor (J 110) aufgebaut ist. Bei Eingangswerten kleiner als der digitale Festwert (hex355) wird der Feldeffekttransistor über das Gatter G eingeschaltet und der Ausgang des Oberwert-D/A-Wandlers MS-DAC um etwa 30 dB gedämpft. Die Wandlung erfolgt nur über den Niederwert-D/A-Wandler LS-DAC, dessen Ausgang immer um 24 dB gedämpft wird. Sein Rauschpegel stellt somit kein Problem dar. Durch die zweite Rauschunterdrückungsschaltung NG2 wird der Dynamikumfang der gesamten Digital/Analog-Wandlerbaugruppe größer als 122 dB. Der Teilwert am Eingang des Oberwert-D/A-Wandlers MS-DAC wird invertiert. Um die Leistungsfähigkeit der Baugruppe auch bei größeren Signalpegeln zu erhalten, sollen nur Bauteile mit kleinen Temperaturkoeffizienten verwendet werden.

Das Ausgangssignal wird nach dem Summierverstärker SV einem Glättungsfilter DG zum Entfernen von Spannungsspitzen zugeführt. Nach einem Ausgangsfilter AIF mit sin x/x Kompensation kann der Pegel des Ausgangssignals gegebenenfalls noch durch einen invertierenden Operationsverstärker justiert werden.

Durch diese Schaltung wird mit relativ billigen 16-Bit-Wandlern und den anderen gängigen und daher leicht erhältlichen Bauteilen ein 20-Bit-Wandler zusammengestellt, der für Audiozwecke sehr gute Ergebnisse liefert. Sie ist auch für Überabtastung (over-sampling) geeignet.

## Patentansprüche

1. Verfahren zur Wandlung des Abtastsignals eines analogen Eingangssignals in einen digitalen Ausgangswert zu L Datenbits, wobei das Abtastsignal in einen digitalen Referenzwert zu M < L Datenbits umgewandelt wird, der wiederum in ein analoges Referenzsignal rückgewandelt und vom Abtastsignal subtrahiert wird, wobei dieses Differenzsignal verstärkt und in einen digitalen Teilwert zu M < N < L Datenbits umgewandelt wird, der mit dem Referenzwert zum Ausgangswert mit L Datenbits zusammengefaßt wird, wobei vom Referenzwert die höherwertigeren und vom Teilwert die niederwertigeren Datenbits des Ausgangswertes gebildet werden und die Summe der Anzahl der Datenbits von Referenz- und Teilwert nicht kleiner als die Anzahl der Datenbits des Ausgangwertes ist, **dadurch gekennzeichnet,** daß der Referenzwert nur während einer Abtastperiode als Teil eines Arbeitszyklus gebildet und bis zur nächst folgenden Abtastperiode gehalten wird und daß die Subtrahierung des Referenzsignals unterdrückt wird, wenn der Pegel des Abtastsignals unter das minimale Quantisierungsniveau zur Referenzwertbildung absinkt.

2. Verfahren nach Anspruch 1, **dadurch gekennzeichnet,** daß die Summe der Datenbits von Referenz- und Teilwert nicht wesentlich größer als die Anzahl der Datenbits des Ausgangwertes ist und daß die überzähligen Datenbits zur Korrektur von Umwandlungsfehlern und zur Anzeige eines Überschreiten des Wertebereiches verwendet werden.

3. Verfahren zur Wandlung eines digitalen Eingangswertes in ein analoges Ausgangssignal, wobei der digitale Eingangswert in zwei Teilwerte aufgespalten und in analoge Teilsignale umgewandelt wird, wobei die höherwertigeren Bits des Eingangswertes den oberen Teilwert bilden und gleichzeitig mit den niederwertigeren Bits in analoge Teilsignale umgewandelt werden, wobei die Zahl der höherwertigeren Bits kleiner als die Zahl der niederwertigeren Bits ist und wobei die Teilsignale mit Pegelanpassung summiert und zum Ausgangssignal zusammengefaßt werden, **dadurch gekennzeichnet,** daß zur Pegelanpassung in einer ersten Stufe der untere Teilwert um mehrere Bits zu niederwertigeren Stellen verschoben und in einer zweiten Stufe das untere Teilsignal um die noch verbleibende Pegeldifferenz gedämpft wird und daß ein digitaler Festwert zum Eingangswert addiert und das Teilsignal des oberen Teilwertes im entsprechenden Maß gedämpft wird, wenn Eingangswerte kleiner als der digitale Festwert sind.

4. Vorrichtung zur Analog/Digital-Wandlung (Fig. 1) nach Anspruch 1 oder 2, wobei das Eingangssignal einem Abtast-Halteglied (SH) zugeführt ist, dessen Ausgang mit dem Analogeingang eines M-Bit Parallel-A/D-Wandlers (FAD) verbunden ist, wobei die Ausgänge des Parallel-A/D-Wandlers (FAD) mit den Digitaleingängen eines Referenz-D/A-Wandlers (RDA) und den höherwertigeren Eingängen eines L-Bit bistabilen Haltespeichers (L) verbunden sind, wobei der Ausgang des Referenz-D/A-Wandlers (RDA) mit dem Ausgang des Abtast-Haltegliedes (SH) in einem Differenzverstärker (DV) zusammengeführt ist, dessen Ausgang mit dem Analogeingang eines N-Bit Teilwert-A/D-Wandlers (AD) verbunden ist und wobei die Ausgänge des Teilwert-A/D-Wandlers (AD) mit den niederwertigeren Eingängen des Haltespeichers (L) verbunden und Eingänge einer Korrekturschaltung (KS) mit den Ausgängen des Parallel-A/D-Wandlers (FAD) verbunden sind, **dadurch gekennzeichnet,** daß ein weiterer Eingang der Korrekturschaltung (KS) mit dem höchstwertigsten Ausgang des Teilwert-A/D-Wandlers (AD) verbunden ist, daß Ausgänge der Korrekturschaltung (KS) mit den höherwertigeren Eingängen des Haltespeichers (L), ein Überlastausgang der Korrekturschaltung (KS) mit einem weiteren Eingang des Haltespeichers (L) und ein Steuerausgang der Korrekturschaltung (KS) mit einer Rauschunterdrückungsschaltung (NG1) verbunden sind und daß die Rauschunterdrückungsschaltung (NG1) zur Unterdrückung des Referenzsignals bei einem Pegel des Abtastsignals unterhalb des minimalen Quantisierungsniveaus für die Referenzwertbildung zwischen den Referenz-D/A-Wandler (RDA) und den Differenzverstärker (DV) geschaltet ist.

5. Vorrichtung zur Digital/Analog-Wandlung (Fig. 2) nach Anspruch 3, wobei ein Datenbus (DB) für Eingangswerte mit einem Niederwert- und einem Oberwert-D/A-Wandler (LS-DAC, MS-DAC) verbunden ist, deren Ausgänge in einem Summierverstärker (SV) zusammengefaßt sind, **dadurch gekennzeichnet,** daß eine Rauschunterdrückungsschaltung (NG2) zwischen dem Oberwert-D/A-Wandler (MS-DAC) und dem Summierverstärker (SV) angeordnet ist, daß die Rauschunterdrückungsschaltung (NG2) zur Addition eines digitalen Festwertes über ein Gatter (G) mit höchstwertigsten Leitungen des Datenbusses (DB) verbunden ist und daß mit einem Aufnahmespeicher (L1) ein Übertragungsspeicher (L2) in Serie geschaltet ist.

## Claims

1. Method for converting the scanning signal of an analogue input signal into a digital output value to form L data bits, wherein the scanning signal is converted into a digital reference value to form M < L data bits, which value is in turn converted back into an analogue reference signal and subtracted from the scanning signal, wherein this differential signal is amplified and converted into a digital partial value to form M < N < L data bits, which partial value is combined with the reference value to form the output value having L data bits, wherein the more significant data bits of the output value are formed by the reference value and the less significant data bits of the output value are formed by the partial value and the total number of data bits of reference and partial value is not lower than the number of data bits of the output value, characterised in that the reference value is formed only during a scanning period as part of an operating cycle and is retained until the next scanning period, and in that subtraction of the reference signal is suppressed when the level of the scanning signal falls below the minimum quantization level for reference value formation.

2. Method according to claim 1, characterised in that the total number of data bits of reference and partial value is not substantially greater than the number of data bits of the output value, and in that excess data bits are used for the correction of conversion errors and for indicating that the range of values has been exceeded.

3. Method for converting a digital input value into an analogue output signal, wherein the digital input value is split into two partial values and is converted into analogue partial signals, wherein the more significant bits of the input value form the upper partial value and are converted, simultaneously with the less significant bits, into analogue partial signals, wherein the number of more significant bits is lower than the number of less significant bits and wherein the partial signals are summed, with matching of levels, and are combined to form the output signal, characterised in that, for matching of levels, in a first step, the lower partial value is displaced by several bits to less significant positions and, in a second step, the lower partial signal is reduced by the remaining difference in level, and in that a digital fixed value is added to the input value and the partial signal of the upper partial value is reduced by the corresponding amount when input values are lower than the digital fixed value.

4. Device for analogue-to-digital conversion (Figure 1) according to claim 1 or 2, wherein the input signal is supplied to a scanning-retention element (SH), the output of which is connected to the analogue input of an M-bit parallel analogue-to-digital converter (FAD), wherein the outputs of the parallel analogue-to-digital converter (FAD) are connected to the digital inputs of a reference digital-to-analogue converter (RDA) and to the more significant inputs of an L-bit bistable retention buffer (L), wherein the output of the reference digital-to-analogue converter (RDA) is joined to the output of the scanning-retention element (SH) in a differential amplifier (DV), the output of which is connected to the analogue input of an N-bit partial value analogue-to-digital converter (AD), and wherein the outputs of the partial value analogue-to-digital converter (AD) are connected to the less significant inputs of the retention buffer (L) and inputs of a correction circuit (KS) are connected to the outputs of the parallel analogue-to-digital converter (FAD), characterised in that a further input of the correction circuit (KS) is connected to the most significant output of the partial value analogue-to-digital converter (AD), in that outputs of the correction circuit (KS) are connected to the more significant inputs of the retention buffer (L), an overload output of the correction circuit (KS) is connected to a further input of the retention buffer (L) and a control output of the correction circuit (KS) is connected to a noise suppression circuit (NG1), and in that the noise suppression circuit (NG1) for suppression of the reference signal when the scanning signal is at a level below the minimum quantization level for reference value formation, is inserted between the reference digital-to-analogue converter (RDA) and the differential amplifier (DV).

5. Device for digital-to-analogue conversion (Figure 2) according to claim 3, wherein a data bus (DB) for input values is connected to a lower-value and an upper-value digital-to-analogue converter (LS-DAC, MS-DAC), the outputs of which are combined in a summing amplifier (SV), characterised in that a noise suppression circuit (NG2) is arranged between the upper-value digital-to-analogue converter (MS-DAC) and the summing amplifier (SV), in that the noise suppression circuit (NG2) for adding a digital fixed value by way of a gate (G) is connected to most significant lines of the data bus (DB) and in that a transmission memory (L2) is connected in series with a receiving memory (L1).

## Revendications

1. Procédé pour la conversion du signal de balayage d'un signal d'entrée analogique en une valeur de sortie numérique en L bits de données, ledit signal de balayage étant converti en une valeur de référence numérique de M < L bits de données, valeur qui est à son tour reconvertie en un signal de référence analogique et soustrait du signal de balayage, tandis que ce signal de différence amplifié est converti en une valeur numérique partielle de M < N < L bits de données laquelle est fusionnée à la valeur de référence pour donner la valeur de sortie de L bits de données, avec formation des bits de poids fort de la valeur de référence et des bits de poids faible de la valeur partielle, de la valeur de sortie, la somme des nombre des bits de données des valeurs de référence et partielle n'étant pas inférieure au nombre des bits de données de la valeur de sortie, caractérisé en ce que la valeur de référence n'est formée que pendant une période de balayage qui représente une partie du cycle opérationnel et qui est maintenue jusqu'à la période de balayage suivante, et en ce que la soustraction du signal de référence est supprimée si le niveau du signal de balayage s'abaisse au-dessous du seuil minimal de quantification pour la formation de la valeur de référence.

2. Procédé selon la revendication 1, caractérisé en ce que la somme des bits de données de la valeur de référence et de la valeur partielle n'est pas sensiblement supérieure au nombre de bits de données de la valeur de sortie et en ce que les bits de données en surnombre sont utilisés pour la correction des erreurs de conversion et pour l'affichage d'un dépassement de la plage des valeurs.

3. Procédé pour la conversion d'une valeur d'entrée numérique en une valeur de sortie analogique, la valeur d'entrée numérique étant fractionnée en deux valeurs partielles et convertie en des signaux partiels analogiques, alors que les bits de poids fort de la valeur d'entrée constituent la valeur partielle supérieure et sont convertis en même temps que les bits à poids faible en signaux partiels analogiques et que le nombre des bits à poids fort est inférieur à celui des bits à poids faible, les signaux partiels étant additionnés avec ajustement du niveau et fusionnés pour délivrer le signal de sortie, caractérisé en ce que, pour l'ajustement du niveau, dans une première étape, la valeur partielle inférieure est décalée de plusieurs bits vers des positions de poids plus faible et, dans une deuxième étape, le signal partiel inférieur est amorti de la différence de niveau encore présente et en ce qu'une valeur fixe numérique est additionnée à la valeur d'entrée, le signal partiel de la valeur partielle supérieure étant amorti dans une proportion correspondante si les valeurs d'entrée sont inférieures à cette valeur fixe numérique.

4. Dispositif pour la mise en oeuvre du procédé de conversion analogique/numérique (figure 1) selon la revendication 1 ou 2, le signal d'entrée étant amené vers un organe de balayage (SH) dont la sortie est reliée à l'entrée analogique d'un convertisseur parallèle A/D (FAD) de M-bit tandis que les sorties de ce convertisseur (FAD) sont reliées aux entrées numériques d'un convertisseur D/A de référence (RDA) et aux entrées de poids fort d'une mémoire bistable de L bit (L), la sortie du convertisseur de référence (RDA) étant fusionnée à la sortie de l'organe de balayage (SH) dans un amplificateur différentiel (DV) dont la sortie est reliée à l'entrée analogique d'un convertisseur de valeur partielle A/D de N-bit (AD) et les sorties de ce convertisseur (AD) étant reliées aux entrées à poids faible de la mémoire (L), alors que des entrées d'un circuit de correction (KS) sont reliées aux sorties du convertissseur (FAD), caractérisé en ce qu'une autre entrée du circuit de correction (KS) est reliée à la sortie de poids fort du convertisseur AD, en ce que des sorties du circuit de correction (KS) sont reliées aux entrées de poids fort de la mémoire (L), qu'une sortie de surcharge du circuit (KS) est reliée à une autre entrée de la mémoire (L) et qu'une sortie de pilotage du circuit (KS) est reliée à un circuit anti-bruit (NG1) et en ce que ce circuit anti-bruit (NG1) est monté, pour la suppression du signal de référence si le niveau du signal de balayage se situe au-dessus du seuil de quantification minimal pour la formation de la valeur de référence, entre le convertisseur (RDA) et l'amplificateur différentiel (DV).

5. Dispositif selon la revendication 3 (figure 2), dans lequel un bus de données (DB) pour des valeurs d'entrée est relié à un convertisseur D/A à poids faible et à poids fort (LS-DAC, MS-DAC) dont les sorties sont fusionnées dans un amplificateur sommateur (SV), caractérisé en ce qu'un circuit anti-bruit (NG2) est disposé entre le convertisseur (MS-DAC) et l'amplificateur sommateur (SV), en ce que ce circuit anti-bruit (NG2) est relié à des conduites de poids fort du bus de données (DB) pour l'addition d'une valeur fixe numérique, par une grille (G), et en ce qu'une mémoire de transmission (L2) est montée en série avec une mémoire d'enregistrement (L1).
